# EUROPEAN PATENT SPECIFICATION

(11) **EP 1 251 609 B1**
(45) Date of publication and mention of the grant of the patent: **19.08.2009**
(21) Application number: 01109682.3
(22) Date of filing: 19.04.2001
(51) Int. Cl.: H01S 5/16, H01S 5/343

(54) **High-power semiconductor window laser device**
Hochleistungs-Halbleiterlaservorrichtung mit Fensterstruktur
Dispositif laser à haute puissance à structure à fenêtre

(43) Date of publication of application: 23.10.2002
(73) Proprietor: FUJIFILM Corporation, Minato-ku Tokyo (JP)
(72) Inventor: Fukunaga, Toshiaki, c/oFuji Photo Film Co., Ltd., Ashigarakami-gun, Kanagawa-ken (JP)
(74) Representative: Klunker . Schmitt-Nilson . Hirsch

(56) References cited:
- US-A- 5 065 403
- US-A- 5 345 460
- FUKUNAGA T ET AL: "HIGHLY RELIABLE OPERATIONS OF HIGH-POWER INGAASP/INGAP/ALGAAS 0.8 MU M SEPARATE CONFINEMENT HETEROSTRUCTURE LASERS" JAPANESE JOURNAL OF APPLIED PHYSICS, PUBLICATION OFFICE JAPANESE JOURNAL OF APPLIED PHYSICS. TOKYO, JP, vol. 34, no. 9B, 15 September 1995 (1995-09-15), pages L1175-L1177, XP000702502 ISSN: 0021-4922
- HIROKI NAITO ET AL: "HIGHLY-RELIABLE CW OPERATION OF 100 MW GAAIAS BURIED TWIN RIDGE SUBSTRATE LASERS WITH NONABSORBING MIRRORS" IEEE JOURNAL OF QUANTUM ELECTRONICS, IEEE INC. NEW YORK, US, vol. 25, no. 6, 1 June 1989 (1989-06-01), pages 1495-1499, XP000054770 ISSN: 0018-9197
- PATENT ABSTRACTS OF JAPAN vol. 013, no. 207 (E-758), 16 May 1989 (1989-05-16) & JP 01 024484 A (SANYO ELECTRIC CO LTD), 26 January 1989 (1989-01-26)

## Description

### BACKGROUND OF THE INVENTION

### Field of the Invention

The present invention relates to a semiconductor laser device which emits laser light having a wavelength of 0.7 to 1.2 µm.

### Description of the Related Art

In many conventional semiconductor laser devices which emit laser light having a wavelength of 0.7 to 1.2 µm, a current confinement structure and an index-guided structure are provided in crystal layers constituting each semiconductor laser device so that each semiconductor laser device oscillates in a fundamental transverse mode.

For example, J. K. Wade et al. ("6.1W continuous wave front-facet power from Al-free active-region (λ=805 nm) diode lasers," Applied Physics Letters, vol. 72, No. 1, 1998, pp.4-6) disclose a semiconductor laser device which emits light in the 805 nm band. The semiconductor laser device comprises an Al-free InGaAsP active layer, an InGaP optical waveguide layer, and InAlGaP cladding layers. In addition, in order to improve the characteristics in the high output power range, the semiconductor laser device includes a so-called large optical cavity (LOC) structure in which the thickness of the optical waveguide layer is increased so as to reduce the light density, and increase the maximum optical output power. However, when the optical power is maximized, currents generated by optical absorption in the vicinity of end faces generate heat, i.e., raise the temperature at the end faces. In addition, the raised temperature reduces the band gaps at the end faces, and therefore the optical absorption is further enhanced to damage the end face. That is, a vicious cycle is formed. This damage is the so-called catastrophic optical mirror damage (COMD). When the optical power reaches the COMD level, the optical output deteriorates with time. Further, the semiconductor laser device is likely to suddenly break down due to the COMD. Therefore, the above semiconductor laser device is not reliable when the semiconductor laser device operates with high output power.

Further, T. Fukunaga et al. ("Highly Reliable Operation of High-Power InGaAsP/InGaP/AlGaAs 0.8 µm Separate Confinement Heterostructure Lasers," Japanese Journal of Applied Physics, vol. 34 (1995) L1175-L1177) disclose a semiconductor laser device which comprises an Al-free active layer, and emits light in the 0.8 µm band. In the semiconductor laser device, an n-type AlGaAs cladding layer, an intrinsic (i-type) InGaP optical waveguide layer, an InGaAsP quantum well active layer, an i-type InGaP optical waveguide layer, a p-type AlGaAs cladding layer, and a p-type GaAs cap layer are formed on an n-type GaAs substrate. However, the maximum optical output power of the semiconductor laser device is typically 1.8 W, i.e., low.

As explained above, the conventional semiconductor laser devices which emit laser light in the 0.8 µm band are not reliable when the semiconductor laser device operates with high output power since the catastrophic optical mirror damage or the like occurs.

### SUMMARY OF THE INVENTION

The object of the present invention is to provide a semiconductor laser device which emits laser light having a wavelength in the range of 0.7 to 1.2 µm, and is reliable even when the semiconductor laser device operates with high output power.

According to the present invention, there is provided a semiconductor laser device including: a GaAs substrate of a first conductive type; a lower cladding layer of the first conductive type, formed on the GaAs substrate; a lower optical waveguide layer made of InGaP of an undoped type or the first conductive type, and formed on the lower cladding layer; an active layer made of InGaAsP or InGaAs, and formed on the lower optical waveguide layer except for near-edge areas of the lower optical waveguide layer which are adjacent to opposite end faces of the semiconductor laser device, where the opposite end faces are perpendicular to a direction of laser light which oscillates in the semiconductor laser device; a first upper optical waveguide layer made of InGaP of an undoped type or a second conductive type, and formed on the active layer; a second upper optical waveguide layer made of InGaP of an undoped type or the second conductive type, and formed over the first upper optical waveguide layer and the near-edge areas of the lower optical waveguide layer; an upper cladding layer of the second conductive type, formed on the second upper optical waveguide layer; and a contact layer of the second conductive type, formed on the upper cladding layer.

Preferably, the semiconductor laser device according to the present invention may also have one or any possible combination of the following additional features (i) to (vi).
(i) In the semiconductor laser device, a ridge structure may be formed by removing more than one portion of the upper cladding layer and the contact layer, and a bottom of the ridge structure may have a width of 1.5 µm or more.
(ii) The semiconductor laser device may further include an additional layer made of InGaAlP of the first conductive type, and formed on the second upper optical waveguide layer other than a stripe area of the second upper optical waveguide layer so as to form a stripe groove realizing a current injection window, the upper cladding layer may be formed over the additional layer so as to fill the stripe groove, and a bottom of the stripe groove may have a width of 1.5 µm or more.
(iii) The active layer may be made of Inₓ₁Ga₁₋ₓ₁As_{1-y1} P_{y1}, where 0≤x1≤0.3, 0≤y1≤0.5, and the product of the strain and the thickness of the active layer may be in a range of -0.15 to +0.15 nm.
   The strain D of a layer formed on the GaAs substrate is defined as D=(c-cₛ)/cₛ, where cₛ and c are the lattice constants of the GaAs substrate and the layer formed on the GaAs substrate, respectively
(iv) The active layer may be a strained quantum well active layer, at least one barrier layer made of InGaP may be formed adjacent to the strained quantum well active layer, the at least one barrier layer may be oppositely strained to the strained quantum well active layer, and the sum of a first product and a second product may be in a range of -0.15 to +0.15 nm, where the first product is the product of the strain and the thickness of the active layer, and the second product is the product of the strain and the total thickness of the at least one barrier layer.
(v) Each of the lower cladding layer and the upper cladding layer may be made of Al_{z1}Ga_{1-z1}As, or Inₓ₃(Al_{z3}Ga_{1-z3})₁₋ₓ₃ As_{1-y3}P_{y3}, where 0.55≤z1≤0.8, x3=0.49y3±0.01, 0<y3≤1, and 0<z3≤1.
(vi) Each of the lower optical waveguide layer and the first upper optical waveguide layers may be made of Inₓ₂Ga₁₋ₓ₂P, where x2=0.49±0.01.

The semiconductor laser devices according to the present invention have the following advantages.

In the semiconductor laser device according to the present invention, near-edge portions of the active layer and the first upper optical waveguide layer are removed, where the near-edge portions are adjacent to opposite end faces of the semiconductor laser device, and the opposite end faces are perpendicular to the direction of laser light which oscillates in the semiconductor laser device. In addition, the second upper optical waveguide layer is formed in the near-edge spaces from which the above near-edge portions of the active layer and the first upper optical waveguide layer are removed, and the second upper optical waveguide layer has a band gap greater than that of the active layer. That is, regions which are unabsorbent of (transparent to) the laser light oscillating in the semiconductor laser device are formed in the vicinity of the opposite end faces, and thus the aforementioned current generation caused by light absorption in the vicinity of the end faces can be prevented. Accordingly, the heat generation in the vicinity of the end faces during the high output power operation can be reduced, and therefore the catastrophic optical mirror damage (COMD) can be prevented, although, as explained before, the catastrophic optical mirror damage (COMD) occurs when the light absorption is enhanced by reduction of the band gap due to the heat generation at the end faces. Consequently, the optical output power of the semiconductor laser device according to the present invention can be greatly increased without the catastrophic optical mirror damage (COMD). That is, the semiconductor laser device according to the present invention is reliable even when the semiconductor laser device operates with high output power.

Further, when regions in the vicinity of opposite end faces of a semiconductor laser device having an internal-stripe type index-guided structure and an oscillation region with a width of 1.5 µm or more, and oscillating in a fundamental transverse mode are made unabsorbent of (transparent to) laser light which oscillates in the semiconductor laser device, the semiconductor laser device is reliable even when the semiconductor laser device operates with high output power.

### DESCRIPTION OF THE DRAWINGS

Fig. 1A is a cross-sectional view of a representative intermediate stage in a process for producing a semiconductor laser device as the first embodiment of the present invention.

Fig. 1B is a cross-sectional view of the semiconductor laser device as the first embodiment of the present invention.

Figs. 2A to 2C are cross-sectional views of a semiconductor laser device as the second embodiment of the present invention.

Figs. 3A to 3C are cross-sectional views of a semiconductor laser device as the third embodiment of the present invention.

Fig. 4A is a cross-sectional view of a representative intermediate stage in a process for producing a semiconductor laser device as the fourth embodiment of the present invention.

Fig. 4B is a cross-sectional view of the semiconductor laser device as the fourth embodiment of the present invention.

### DESCRIPTION OF PREFERRED EMBODIMENTS

Embodiments of the present invention are explained in detail below with reference to drawings.

### First Embodiment

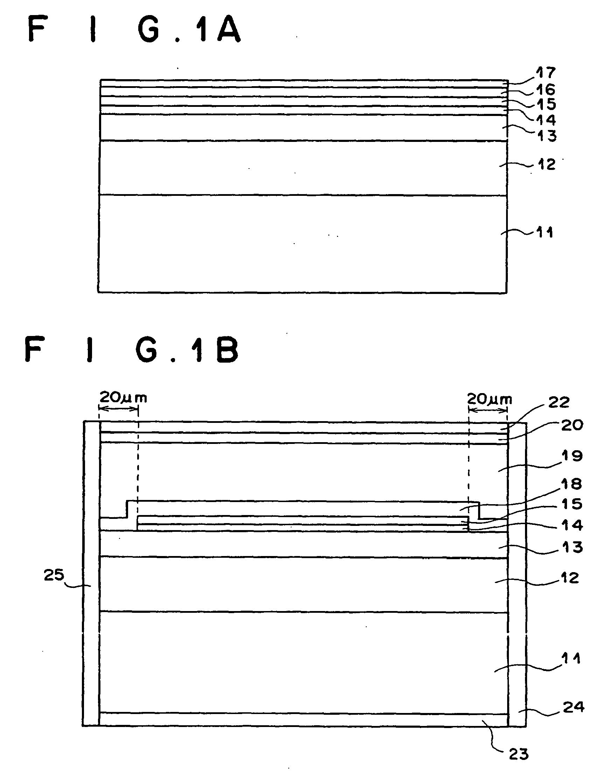

Fig. 1A is a cross-sectional view of a representative intermediate stage in a process for producing a semiconductor laser device as the first embodiment of the present invention, and Fig. 1B is a cross-sectional view of the semiconductor laser device as the first embodiment of the present invention. The cross sections exhibited in Figs. 1A and 1B are parallel to the direction of the laser light emitted from the semiconductor laser device.

First, as illustrated in Fig. 1A, an n-type Al_{z1}Ga_{1-z1}As lower cladding layer 12 (0.55≤z1≤0.8), an n-type or i-type In_{0.49}Ga_{0.51}P lower optical waveguide layer 13, an Inₓ₃Ga₁₋ₓ₃As_{1-y3}P_{y3} quantum well active layer 14 (0≤x3≤0.4, 0≤y3≤0.5), a p-type or i-type In_{0.49}Ga_{0.51}P first upper optical waveguide layer 15, and a GaAs cap layer 16 having a thickness of approximately 10 nm are formed on an n-type GaAs substrate 11 by organometallic vapor phase epitaxy. Then, a SiO₂ film 17 is formed over the n-type GaAs cap layer 16.

Thereafter, in each semiconductor laser device, near-edge portions of the SiO₂ film 17, which are adjacent to the end faces of the semiconductor laser device, are removed so as to expose near-edge portions of the n-type GaAs cap layer 16, where each of the near-edge portions is adjacent to an end face of the semiconductor laser device, and has a width of about 20 µm in the direction perpendicular to the end face. Since, in the actual production process, a plurality of semiconductor laser devices are formed in a wafer, stripe areas of the SiO₂ film 17 on the wafer, each including boundaries (corresponding to end faces) of the semiconductor laser devices in its center and having a width of about 40 µm, are removed.

Next, the near-edge portions of the n-type GaAs cap layer 16 are etched off with a sulfuric acid etchant by using the remaining areas of the SiO₂ film 17 as a mask so as to expose near-edge portions of the p-type or i-type In_{0.49}Ga_{0.51}P first upper optical waveguide layer 15. Then, the near-edge portions of the p-type or i-type In_{0.49}Ga_{0.51}P first upper optical waveguide layer 15 are etched off with a hydrochloric acid etchant until near-edge portions of the Inₓ₃Ga₁₋ₓ₃As_{1-y3}P_{y3} quantum well active layer 14 are exposed. Next, the remaining areas of the SiO₂ film 17 are removed, and then the remaining portions of the n-type GaAs cap layer 16 and the near-edge portions of the Inₓ₃Ga₁₋ₓ₃As_{1-y3}P_{y3} quantum well active layer 14 are removed by using a sulfuric acid etchant so as to expose near-edge portions of the n-type or i-type In_{0.49}Ga_{0.51}P lower optical waveguide layer 13.

Finally, a p-type or i-type In_{0.49}Ga_{0.51}P second upper optical waveguide layer 18, a p-type Al_{z1}Ga_{1-z1}As upper cladding layer 19 (0.55≤z1≤0.8), and a p-type GaAs contact layer 20 are formed over the remaining area of the p-type or i-type In_{0.49}Ga_{0.51}P first upper optical waveguide layer 15 and the exposed near-edge portions of the n-type or i-type In_{0.49}Ga_{0.51}P lower optical waveguide layer 13. Then, a p electrode 22 is formed on the p-type GaAs contact layer 20. In addition, the exposed surface of the substrate 11 is polished, and an n electrode 23 is formed on the polished surface of the substrate 11. Next, both end faces of the layered structure are cleaved, and a high reflectance coating 24 and a low reflectance coating 25 are provided on the respective end faces so as to form a resonator. Then, the above construction is formed into a chip.

In the semiconductor laser device as the first embodiment of the present invention, laser light oscillates between the above end faces respectively provided with the high reflectance coating 24 and the low reflectance coating 25, and exits through the end face provided with the low reflectance coating 25. Since the near-edge portions of the quantum well active layer 14 are removed, the heat generation due to the light absorption in the vicinity of the end faces can be suppressed, and therefore the catastrophic optical mirror damage (COMD) can be prevented.

The active layer may have a composition which realizes an active layer of a compressive strain type, a type which lattice-matches with the substrate, or a tensile strain type.

When the active layer is a strained quantum well type, at least one InGaP barrier layer which is oppositely strained to the active layer may be arranged adjacent to the active layer so as to compensate for the strain of the active layer. In this case, it is preferable that the sum of the product of the strain and the thickness of the active layer and the product of the strain and the total thickness of the at least one barrier layer is in the range of -0.15 to +0.15 nm.

Although the electrodes are formed on substantially the entire surface of the construction of the first embodiment, the present invention can be applied to gain-guided stripe type semiconductor laser devices in which a striped insulation layer is formed, or index-guided semiconductor laser devices which are formed by using the conventional lithography or dry etching, or semiconductor laser devices having a diffraction lattice, or integrated circuits.

The active layer may have a multiple quantum well structure made of InGaP and InGaAsP layers. In this case, it is preferable that the product sum of the tensile strains and thicknesses of the respective tensile strained layers is in the range of -0.15 to +0.15 nm. In addition, it is preferable that near-edge portions of the multiple quantum well active layer which are adjacent to the end faces are etched off by alternatively using a sulfuric acid etchant and a hydrochloric acid etchant, until the lower optical waveguide is exposed. Thereafter, the near-edge spaces from which the near-edge portions of the multiple quantum well active layer are removed are filled with the p-type or i-type In_{0.49}Ga_{0.51}P second upper optical waveguide layer 18.

### Second Embodiment

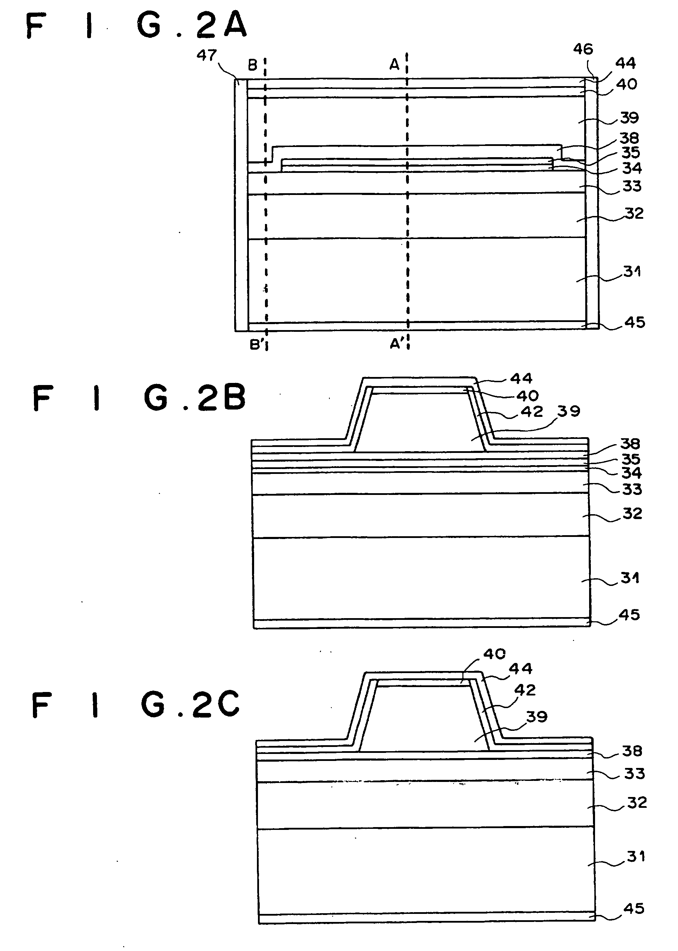

Figs. 2A to 2C are cross-sectional views of a semiconductor laser device as the second embodiment of the present invention. The cross section shown in Fig. 2A is parallel to the direction of the laser light emitted from the semiconductor laser device. Fig. 2B shows the cross section B-B' in the vicinity of the end face, and Fig. 2C shows the cross section A-A' in the central portion of the semiconductor laser device.

First, as illustrated in Fig. 2A, an n-type Al_{z1}Ga_{1-z1}As lower cladding layer 32 (0.55≤z1≤0.8), an n-type or i-type In_{0.49}Ga_{0.51}P lower optical waveguide layer 33, an Inₓ₃Ga₁₋ₓ₃As_{1-y3}P_{y3} quantum well active layer 34 (0≤x3≤0.3, 0≤y3≤0.5), a p-type or i-type In_{0.49}Ga_{0.51}P first upper optical waveguide layer 35, and a GaAs cap layer 36 (not shown) having a thickness of approximately 10 nm are formed on an n-type GaAs substrate 31 by organometallic vapor phase epitaxy. Then, a SiO₂ film 37 (not shown) is formed over the n-type GaAs cap layer 36.

Thereafter, in each semiconductor laser device, near-edge portions of the SiO₂ film 37, which are adjacent to the end faces of the semiconductor laser device, are removed so as to expose near-edge portions of the n-type GaAs cap layer 36, where each of the near-edge portions is adjacent to an end face of the semiconductor laser device, and has a width of about 20 µm in the direction perpendicular to the end face. Since, in the actual production process, a plurality of semiconductor laser devices are formed in a wafer, stripe areas of the SiO₂ film 37 on the wafer, each including boundaries (corresponding to end faces) of the semiconductor laser devices in its center and having a width of about 40 µm, are removed.

Next, the near-edge portions of the n-type GaAs cap layer 36 is etched off with a sulfuric acid etchant by using the remaining areas of the SiO₂ film 37 as a mask so as to expose near-edge portions of the p-type or i-type In_{0.49}Ga_{0.51}P first upper optical waveguide layer 35. Then, the near-edge portions of the p-type or i-type In_{0.49}Ga_{0.51}P first upper optical waveguide layer 35 are etched off with a hydrochloric acid etchant until near-edge portions of the Inₓ₃Ga₁₋ₓ₃As_{1-y3}P_{y3} quantum well active layer 34 are exposed. Next, the remaining areas of the SiO₂ film 37 are removed, and then the remaining portions of the n-type GaAs cap layer 36 and the near-edge portions of the Inₓ₃Ga₁₋ₓ₃As_{1-y3}P_{y3} quantum well active layer 34 are removed by using a sulfuric acid etchant so as to expose near-edge portions of the n-type or i-type In_{0.49}Ga_{0.51}P lower optical waveguide layer 33.

Thereafter, a p-type or i-type In_{0.49}Ga_{0.51}P second upper optical waveguide layer 38, a p-type Al_{z1}Ga_{1-z1}As upper cladding layer 39, and a p-type GaAs contact layer 40 are formed over the remaining area of the p-type or i-type In_{0.49}Ga_{0.51}P first upper optical waveguide layer 35 and the exposed near-edge portions of the n-type or i-type In_{0.49}Ga_{0.51}P lower optical waveguide layer 33.

Then, an insulation film 41 (not shown) is formed on the p-type GaAs contact layer 40, and parallel stripe areas of the insulation film 41, each having a width of about 6 µm, are removed by conventional lithography so as to leave a stripe area of the insulation film 41 having a width of about 3 µm. Next, the layered structure formed as above is etched to the depth of the upper surface of the p-type In_{0.49}Ga_{0.51}P second upper optical waveguide layer 38 by wet etching using the remaining areas of the insulation film 41 as a mask so as to form a ridge stripe structure, as illustrated in Fig. 2B. When a solution of sulfuric acid and hydrogen peroxide is used as an etchant, the etching automatically stops at the upper boundary of the p-type In_{0.49}Ga_{0.51}P second upper optical waveguide layer 38.

The total thickness of the first and second upper optical waveguide layers is such a value that a fundamental transverse mode oscillation is achieved even when the semiconductor laser device operates with high output power.

Thereafter, an insulation layer 42 is formed over the layered structure formed as above, and a stripe area of the insulation layer 42 at the top of the ridge stripe structure is removed by using conventional lithography. Then, a p electrode 44 is formed on the top of the ridge stripe structure. In addition, the exposed surface of the substrate 31 is polished, and an n electrode 45 is formed on the polished surface of the substrate 31. Next, both end faces of the layered structure are cleaved, and a high reflectance coating 46 and a low reflectance coating 47 are provided on the respective end faces so as to form a resonator. Then, the above construction is formed into a chip.

As illustrated in Fig. 2A, the Inₓ₃Ga₁₋ₓ₃As_{1-y3}P_{y3} quantum well active layer 34 and the p-type or i-type In_{0.49}Ga_{0.51}P first upper optical waveguide layer 35 are formed over the entire area except for near-edge areas which are adjacent to the end faces. That is, the Inₓ₃Ga₁₋ₓ₃As_{1-y3}P_{y3} quantum well active layer 34 and the p-type or i-type In_{0.49}Ga_{0.51}P first upper optical waveguide layer 35 are removed in the vicinity of the end faces of the semiconductor laser device. Therefore, near-edge regions of the semiconductor laser device through which laser light passes are unabsorbent of (transparent to) the laser light which oscillates in the semiconductor laser device, and heat generation in the vicinity of the end faces can be suppressed. Thus, the COMD level can be raised. That is, the semiconductor laser device as the second embodiment of the present invention is also reliable even when the semiconductor laser device operates with high output power.

The above semiconductor laser device as the second embodiment oscillates in a fundamental transverse mode. However, when the present invention is applied to a semiconductor laser device which includes an oscillation region having a width of 1.5 µm or more, the semiconductor laser device can also operate with high output power and low noise even in multiple modes.

### Third Embodiment

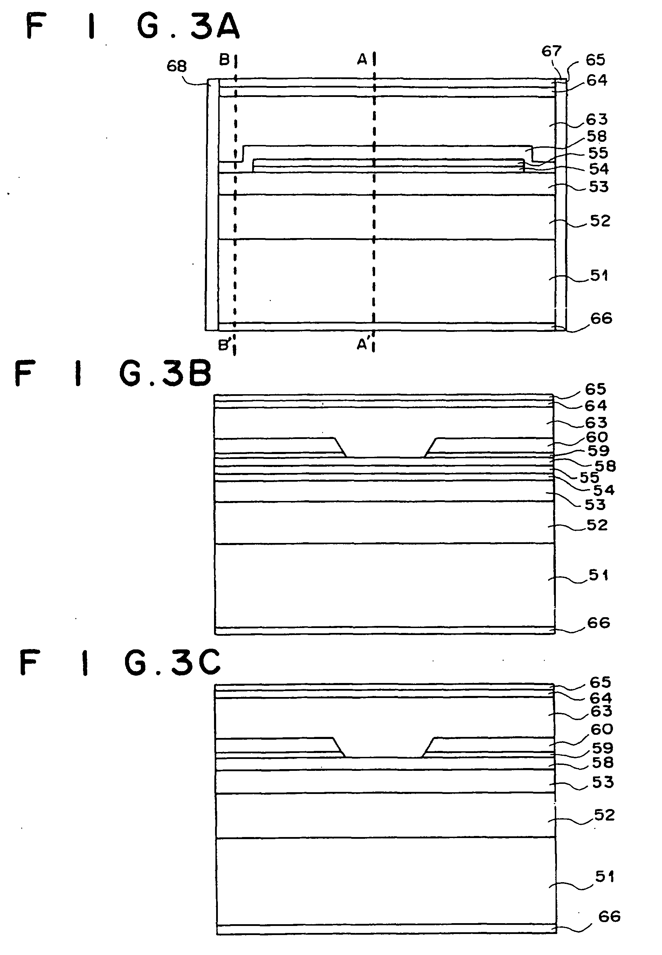

Figs. 3A to 3C are cross-sectional views of a semiconductor laser device as the third embodiment of the present invention. The cross section shown in Fig. 3A is parallel to the direction of the laser light emitted from the semiconductor laser device. Fig. 3B shows the cross section B-B' in the vicinity of the end face, and Fig. 3C shows the cross section A-A' in the central portion of the semiconductor laser device.

First, as illustrated in Fig. 3A, an n-type In_{0.49}(Ga_{1-z2} Al_{z2})_{0.51}P lower cladding layer 52 (0.1≤z2<z3), an n-type or i-type In_{0.49}Ga_{0.51}P lower optical waveguide layer 53, an Inₓ₃Ga₁₋ₓ₃ As_{1-y3}P_{y3} quantum well active layer 54 (0≤x3≤0.3, 0≤y3≤0.5), a p-type or i-type In_{0.49}Ga_{0.51}P first upper optical waveguide layer 55, and a GaAs cap layer 56 (not shown) having a thickness of approximately 10 nm are formed on an n-type GaAs substrate 51 by organometallic vapor phase epitaxy. Then, a SiO₂ film 57 (not shown) is formed over the n-type GaAs cap layer 56.

Next, in each semiconductor laser device, near-edge portions of the SiO₂ film 57, which are adjacent to the end faces of the semiconductor laser device, are removed so as to expose near-edge portions of the n-type GaAs cap layer 56, where each of the near-edge portions is adjacent to an end face of the semiconductor laser device, and has a width of about 20 µm in the direction perpendicular to the end face. Since, in the actual production process, a plurality of semiconductor laser devices are formed in a wafer, stripe areas of the SiO₂ film 57 on the wafer, each including boundaries (corresponding to end faces) of the semiconductor laser devices in its center and having a width of about 40 µm, are removed.

Thereafter, the near-edge portions of the n-type GaAs cap layer 56 are etched off with a sulfuric acid etchant by using the remaining areas of the SiO₂ film 57 as a mask so as to expose near-edge portions of the p-type or i-type In_{0.49}Ga_{0.51}P first upper optical waveguide layer 55. Then, the near-edge portions of the p-type or i-type In_{0.49}Ga_{0.51}P first upper optical waveguide layer 55 are etched off with a hydrochloric acid etchant until near-edge portions of the Inₓ₃Ga₁₋ₓ₃As_{1-y3}P_{y3} quantum well active layer 54 are exposed. Next, the remaining areas of the SiO₂ film 57 are removed, and then the remaining portions of the n-type GaAs cap layer 56 and the near-edge portions of the Inₓ₃Ga₁₋ₓ₃As_{1-y3}P_{y3} quantum well active layer 54 are removed by using a sulfuric acid etchant so as to expose near-edge portions of the n-type or i-type In_{0.49}Ga_{0.51}P lower optical waveguide layer 53.

Next, a p-type In_{0.49}Ga_{0.51}P second upper optical waveguide layer 58, a p-type Inₓ₄Ga₁₋ₓ₄As_{1-y4}P_{y4} etching stop layer 59 (0≤x4≤0.3, 0≤y4≤0.6), an n-type In_{0.49}(Ga_{1-z3}Al_{z3})_{0.51}P current confinement layer 60 (z2<z3≤1), and an n-type GaAs cap layer 61 (not shown) are formed on the layered structure formed as above. Then, a resist is applied to the n-type GaAs cap layer 61, and a stripe area of the resist having a width of about 3 µm and extending in the direction perpendicular to the end faces is removed by using conventional lithography in order to form a current injection window. Next, a stripe area of the n-type GaAs cap layer 61, which is exposed by the above removal of the stripe area of the resist, is etched off with a sulfuric acid etchant by using the remaining resist as a resist mask, and then a stripe area of the n-type n_{0.49}(Ga_{1-z2} Al_{z2})_{0.51}P current confinement layer 60 under the removed stripe area of the n-type GaAs cap layer 61 is etched off with a hydrochloric acid etchant by using the remaining resist as a resist mask. Next, the remaining resist is removed, and the remaining area of the n-type GaAs cap layer 61 and a stripe area of the p-type In_{0.49}(Ga_{1-z3}Al_{z3})_{0.51}P etching stop layer 59 are etched off with a sulfuric acid etchant.

Subsequently, a p-type In_{0.49}(Ga_{1-z1}Al_{z1})_{0.51}P upper cladding layer 63 and a p-type GaAs contact layer 64 are formed over the layered structure formed as above. The total thickness of the first and second upper optical waveguide layers 55 and 58 is such a value that a fundamental transverse mode oscillation is achieved even when the semiconductor laser device operates with high output power. Finally, a p electrode 65 is formed on the p-type GaAs contact layer 64. In addition, the exposed surface of the substrate 51 is polished, and an n electrode 66 is formed on the polished surface of the substrate 51. Next, both end faces of the layered structure are cleaved, and a high reflectance coating 67 and a low reflectance coating 68 are provided on the respective end faces so as to form a resonator. Then, the above construction is formed into a chip.

As illustrated in Fig. 3B, the semiconductor laser device as the third embodiment of the present invention includes an internal-stripe type index-guided structure realized by the provision of the current confinement layer, and the Inₓ₃Ga₁₋ₓ₃As_{1-y3}P_{y3} quantum well active layer 54 and the p-type or i-type In_{0.49}Ga_{0.51}P first upper optical waveguide layer 55 extend over the entire area except for the near-edge areas which are adjacent to the end faces of the semiconductor laser device. That is, as illustrated in Fig. 3C, the Inₓ₃Ga₁₋ₓ₃ As_{1-y3}P_{y3} quantum well active layer 54 and the p-type or i-type In_{0.49}Ga_{0.51}P first upper optical waveguide layer 55 are removed in the vicinity of the end faces of the semiconductor laser device. Therefore, near-edge regions (i.e., regions in the vicinity of the end faces) of the semiconductor laser device are unabsorbent of (transparent to) the laser light which oscillates in the semiconductor laser device, and heat generation in the vicinity of the end faces can be suppressed. Thus, the COMD level can be raised. That is, the semiconductor laser device as the third embodiment of the present invention is also reliable even when the semiconductor laser device operates with high output power.

Due to the above construction, the above semiconductor laser device as the third embodiment oscillates in a fundamental transverse mode even when the semiconductor laser device operates with high optical output power. However, when the present invention is applied to a semiconductor laser device which includes an oscillation region having a width of 1.5 µm or more, the semiconductor laser device can also operate with high output power and low noise even in multiple modes.

### Fourth Embodiment

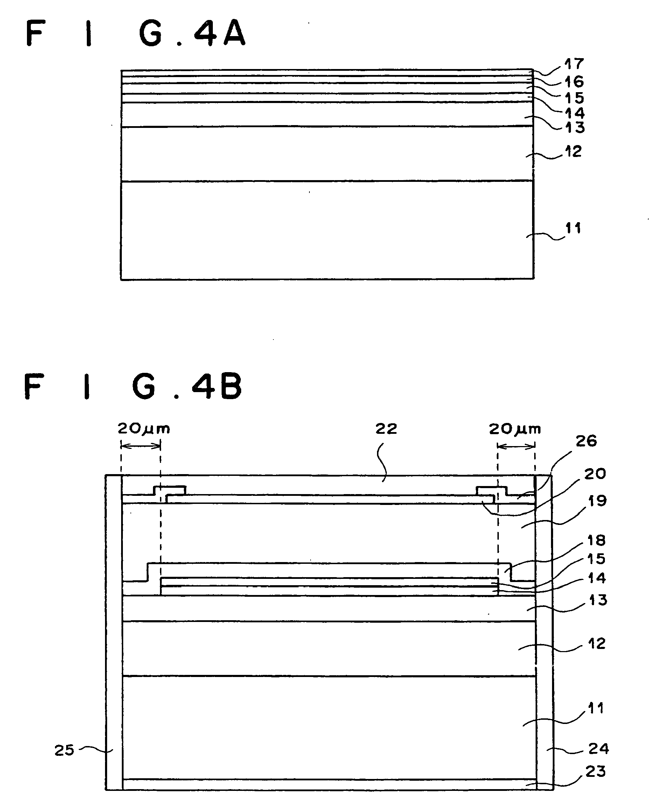

Fig. 4A is a cross-sectional view of a representative intermediate stage in a process for producing a semiconductor laser device as the fourth embodiment of the present invention, and Fig. 4B is a cross-sectional view of the semiconductor laser device as the fourth embodiment of the present invention. The cross sections shown in Figs. 4A and 4B are parallel to the direction of the laser light emitted from the semiconductor laser device.

The layers from the n-type GaAs substrate 11 to the p-type Al_{z1}Ga_{1-z1}As upper cladding layer 19 of the semiconductor laser device as the fourth embodiment of the present invention are identical to the corresponding layers of the construction of the first embodiment. However, in the fourth embodiment, after the p-type GaAs contact layer 20 is formed on the p-type Al_{z1}Ga_{1-z1}As upper cladding layer 19, near-edge portions (i.e., portions in the vicinity of the end faces) of the p-type GaAs contact layer 20 are removed by using conventional lithography. Next, an insulation layer 26 is formed over the above layered structure, and an area of the insulation layer 26 corresponding to a current injection window is removed so as to expose the corresponding area of the p-type GaAs contact layer 20 as illustrated in Fig. 4B. Then, a p electrode 22 is formed over the p-type GaAs contact layer 20 and the remaining portions of the insulation layer 26. In addition, the exposed surface of the substrate 11 is polished, and an n electrode 23 is formed on the polished surface of the substrate 11. Finally, the above construction is formed into a chip in the same manner as the first embodiment.

### Additional Matters to First to Fourth Embodiments

(i) Although n-type GaAs substrates are used in the constructions of the first to fourth embodiments, instead, p-type GaAs substrates may be used. When the GaAs substrates are a p-type, the conductivity types of all of the other layers in the constructions of the first to fourth embodiments should be inverted.
(ii) When the active layers in the semiconductor laser devices as the first to fourth embodiments are Inₓ₃Ga₁₋ₓ₃As_{1-y3}P_{y3} compressive strain quantum well active layers (0<x3≤0.4, 0≤y3≤0.1), the oscillation wavelengths of the semiconductor laser devices as the first to fourth embodiments can be controlled in the range of 700 to 1,200 nm.
(iii) Each layer in the semiconductor laser devices as the first to fourth embodiments may be formed by molecular beam epitaxy using solid or gas raw material.
(iv) In addition, all of the contents of Japanese Patent Application, No. 11(1999)-348527 are incorporated into this specification by reference.

## Claims

1. A semiconductor laser device comprising:
a GaAs substrate of a first conductive type;
a lower cladding layer of said first conductive type, formed on said GaAs substrate;
a lower optical waveguide layer made of InGaP of an undoped type or said first conductive type, and formed on said lower cladding layer;
an active layer made of InGaAsP or InGaAs, **characterized in that** said active layer is formed on said lower optical waveguide layer except for near-edge areas of said lower optical waveguide layer which are adjacent to opposite end faces of said semiconductor laser device, where said opposite end faces are perpendicular to a direction of laser light which oscillates in said semiconductor laser device;
a first upper optical waveguide layer made of InGaP of an undoped type or a second conductive type, and formed on said active layer;
a second upper optical waveguide layer made of InGaP of an undoped type or said second conductive type, and formed over said first upper optical waveguide layer and said near-edge areas of said lower optical waveguide layer;
an upper cladding layer of said second conductive type, formed on said second upper optical waveguide layer; and
a contact layer of said second conductive type, formed on said upper cladding layer.

2. A semiconductor laser device according to claim 1, wherein a ridge structure is formed by removing more than one portion of said upper cladding layer and said contact layer, and a bottom of said ridge structure has a width of 1.5 µm or more.

3. A semiconductor laser device according to claim 1, further comprising an additional layer made of InGaAlP of said first conductive type, and formed on said second upper optical waveguide layer other than a stripe area of said second upper optical waveguide layer so as to form a stripe groove realizing a current injection window, said upper cladding layer is formed over said additional layer so as to fill said stripe groove, and a bottom of said stripe groove has a width of 1.5 µm or more.

4. A semiconductor laser device according to claim 1, wherein said active layer is made of Inₓ₁Ga₁₋ₓ₁As_{1-y1}P_{y1}, where 0≤x1≤0.3, and 0≤y1≤0.5, and a product of a strain and a thickness of said active layer is in a range of -0.15 to +0.15 nm.

5. A semiconductor laser device according to claim 1, wherein said active layer is a strained, single or multiple quantum well active layer, barrier layers made of InGaP are formed immediately above and under said strained quantum well active layer, said at least one barrier layer is oppositely strained to said strained quantum well active layer, and a sum of a first product and a second product is in a range of -0.15 to +0.15 nm, where said first product is a product of a strain and a thickness of said active layer, and said second product is a product of a strain and a total thickness of said at least one barrier layer.

6. A semiconductor laser device according to claim 1, wherein each of said lower cladding layer and said upper cladding layer is made of Al_{z1}Ga_{1-z1}As, or Inₓ₃(Al_{z3}Ga_{1-z3})₁₋ₓ₃As_{1-y3}P_{y3}, where 0.55≤z1≤0.8, x3=0.49y3±0.01, 0<y3≤1, and 0<z3≤1.

7. A semiconductor laser device according to claim 1, wherein each of said lower optical waveguide layer and said first upper optical waveguide layers is made of Inₓ₂Ga₁₋ₓ₂P, where x2=0.49±0.01.

## Patentansprüche

1. Halbleiter-Laserbauelement, umfassend:
ein GaAs-Substrat eines ersten Leitungstyps;
eine untere, auf dem GaAs-Substrat gebildete Mantelschicht des ersten Leitungstyps;
eine auf der unteren Mantelschicht gebildete untere optische Wellenleiterschicht aus InGaP vom undotierten Typ oder vom ersten Leitungstyp;
eine aktive Schicht aus InGaAsP oder InGaAs,
**dadurch gekennzeichnet, dass** die aktive Schicht auf der unteren optischen Wellenleiterschicht mit Ausnahme der kantennahen Bereiche der unteren Wellenleiterschicht benachbart zu den Stirnflächen des Halbleiter-Laserbauelements ausgebildet ist, wobei die einander abgewandten Stirnflächen rechtwinklig zu einer Richtung des in dem Halbleiter-Laserbauelements schwingenden Laserlichts angeordnet sind;
eine auf der aktiven Schicht gebildete erste obere optische Wellenleiterschicht aus lnGaP vom undotierten Typ oder von einem zweiten Leitungstyp;
eine zweite obere optische Wellenleiterschicht aus InGaP vom undotierten Typ oder vom zweiten Leitungstyp, ausgebildet über der ersten oberen Wellenleiterschicht und den kantennahen Bereichen der unteren optischen Wellenleiterschicht;
eine auf der zweiten oberen optischen Wellenleiterschicht gebildete obere Mantelschicht des zweiten Leitungstyps; und
eine auf der oberen Mantelschicht gebildete Kontaktschicht des zweiten Leitungstyps.

2. Bauelement nach Anspruch 1, bei der eine Rippenstruktur gebildet ist durch Entfernen von mehr als einem Teil der oberen Mantelschicht und der Kontaktschicht, wobei ein Boden der Rippenstruktur eine Breite von 1,5 µm oder mehr aufweist.

3. Bauelement nach Anspruch 1, weiterhin umfassend eine Zusatzschicht aus InGaAlP des ersten Leitungstyps, gebildet auf der oberen optischen Wellenleiterschicht mit Ausnahme eines Streifenbereichs der zweiten oberen optischen Wellenleiterschicht, um eine Streifen-Nut zur Realisierung eines Strominjektionsfensters zu bilden, wobei die obere Mantelschicht über der zusätzlichen Schicht gebildet ist, um die Streifennut auszufüllen, und ein Boden der Streifennut eine Breite von 1,5 µm oder mehr aufweist.

4. Bauelement nach Anspruch 1, bei dem die aktive Schicht aus Inₓ₁Ga₁₋ₓ₁As_{1-y1}P_{y1} mit 0≤x1≤ 0,3 und 0≤y1≤ 0,5 gebildet ist, wobei ein Produkt aus Spannung und Dicke der aktiven Schicht im Bereich von -0,15 bis +0,15 nm liegt.

5. Bauelement nach Anspruch 1, bei dem die aktive Schicht eine gespannte, einzelne oder vielfache aktive Quantentopfschicht ist, das unmittelbar oberhalb und unterhalb der gespannten aktiven Quantentopfschicht Barrierenschichten aus InGaAP gebildet sind, von denen mindestens eine Barrierenschicht entgegen der gespannten aktiven Quantentopfschicht gespannt ist, und eine Summe eines ersten Produkts und eines zweiten Produkts in einem Bereich von -0,15 bis +0,15 nm liegt, wobei das erste Produkt ein Produkt aus Spannung und Dicke der aktiven Schicht ist und das zweite Produkt ein Produkt aus Spannung und Gesamtdicke der mindestens einen Barrierenschicht ist.

6. Bauelement nach Anspruch 1, bei dem sowohl die untere Mantelschicht als auch die obere Mantelschicht aus Al_{z1}Ga_{1-z1}As oder Inₓ₃(Al_{z3}Ga_{1-z3})₁₋ₓAs_{1-y3}P_{y3} mit 0,55≤z1≤0,8; x3 = 0,49y3 ± 0,01; 0<y3≤1 und 0<z3≤1 gebildet ist.

7. Bauelement nach Anspruch 1, bei dem sowohl die untere als auch die erste obere optische Wellenleiterschicht aus lnₓ₂Ga₁₋ₓ₂P mit x2 = 0,49 ± 0,01 besteht.

## Revendications

1. Dispositif laser à semi-conducteur comportant :
un substrat de GaAs d'un premier type conducteur;
une couche de revêtement inférieure dudit premier type conducteur, formée sur ledit substrat GaAs ;
une couche guide d'ondes optique inférieure réalisée en InGaP de type non dopé ou dudit premier type conducteur, et formée sur ladite couche de revêtement inférieure ;
une couche active réalisée en InGaAsP ou en InGaAs, **caractérisé en ce que** ladite couche active est formée sur ladite couche guide d'ondes optiques inférieure sauf pour les zones proches des bords de ladite de guide d'ondes optiques inférieure qui sont adjacentes aux surfaces terminales opposées du dispositif laser à semi-conducteur, où lesdites surfaces terminales opposées sont perpendiculaires à une direction de la lumière laser qui oscille dans ledit dispositif laser à semi-conducteur ;
une première couche guide d'ondes optiques supérieure réalisée en InGaP de type non dopé ou d'un second type conducteur, et formée sur ladite couche active ;
une seconde couche guide d'ondes optique supérieure réalisée en InGaP de type non dopé ou dudit second type conducteur, et formée sur ladite première couche guide d'ondes optiques supérieure et lesdites zones proches des bords de ladite couche guide d'ondes optiques inférieure;
une couche de revêtement supérieure dudit second type conducteur, formée sur ladite seconde couche guide d'ondes optiques supérieure ; et
une couche de contact dudit second type conducteur, formée sur ladite couche de revêtement supérieure.

2. Dispositif laser à semi-conducteur selon la revendication 1, dans lequel une structure à nervure est formée en supprimant plus d'une partie de ladite couche de revêtement supérieure et de ladite couche de contact, et un fond de ladite structure à nervure possède une largeur de 1,5 µm ou plus.

3. Dispositif laser à semi-conducteur selon la revendication 1, comportant en outre une couche supplémentaire réalisée en InGaAlP dudit premier type conducteur, et formée sur ladite seconde couche guide d'ondes optiques supérieure autre qu'une zone de ruban de ladite seconde couche guide d'ondes optiques supérieure de manière à former une rainure en forme de ruban réalisant une fenêtre d'injection de courant, ladite couche de revêtement supérieure est formée sur ladite couche supplémentaire de manière à remplir ladite rainure en forme de ruban, et un fond de ladite rainure en forme de ruban présente une largeur de 1,5 µm au plus.

4. Dispositif laser à semi-conducteur selon la revendication 1, dans lequel ladite couche active est réalisée en Inₓ₁GA₁₋ₓ₁As_{1-y1}P_{y1}, où 0≤x1≤0,3, et 0 ≤y1≤ 0,5, et un produit d'une contrainte et d'une épaisseur de ladite couche active se trouve dans une plage comprise entre -0,15 et +0,15 nm.

5. Dispositif laser à semi-conducteur selon la revendication 1, dans lequel ladite couche active est une couche active à puits quantiques uniques ou multiples sous contrainte, des couches barrières réalisées en InGaP sont formées immédiatement au-dessus et en dessous de ladite couche active sous contrainte à puits quantiques, ladite au moins une couche barrière est sous contrainte de façon opposée à ladite couche active à puits quantiques sous contrainte, et une somme d'un premier produit et d'un second produit se trouve dans une plage comprise entre -0,15 et +0,15 nm, où ledit premier produit est un produit d'une contrainte et d'une épaisseur de ladite couche active, et ledit second produit est un produit d'une contrainte et d'une épaisseur totale de ladite au moins une couche barrière.

6. Dispositif laser à semi-conducteur selon la revendication 1, dans lequel chacune de ladite couche de revêtement inférieure et de ladite couche de revêtement supérieure est réalisée en Al_{z1}Ga_{1-z1}As, ou en Inₓ₃(Al_{z3}Ga_{1-z3})₁₋ₓ₃As_{1-y3}P_{y3}, où 0,55 ≤ z1 ≤ 0,8, x3 = 0,49y3±0,01, 0 < y3 ≤ 1, et 0 < z3 ≤ 1.

7. Dispositif laser à semi-conducteur selon la revendication 1, dans lequel chacune de ladite couche guide d'ondes optiques inférieure et de ladite première couche guide d'ondes optiques supérieure est réalisée en Inₓ₂Ga₁₋ₓ₂P, où x2 = 0,49±0,01.
